# EUROPÄISCHE PATENTSCHRIFT

(11) **EP 0 568 838 B1**
(45) Veröffentlichungstag und Bekanntmachung des Hinweises auf die Patenterteilung: **18.11.1998**
(21) Anmeldenummer: 93105900.0
(22) Anmeldetag: 10.04.1993
(51) Int. Cl.: H01L 31/16, H01L 31/167, H04B 10/00

(54) **Verfahren zum Herstellen eines optoelektronischen Koppelelements**
Method of manufacturing an optoelectronic coupling element
Procédé de fabrication d'un élément de couplage optoélectronique

(30) Priorität: 04.05.1992 DE 4214792
(43) Veröffentlichungstag der Anmeldung: 10.11.1993
(73) Patentinhaber: TEMIC TELEFUNKEN microelectronic GmbH, 74072 Heilbronn (DE)
(72) Erfinder: Kofler, Albin, A-5274 Burgkirchen (AT)
(74) Vertreter: Maute, Hans-Jürgen, Dipl.-Ing.

(56) Entgegenhaltungen:
- WO-A-86/01458
- DE-A- 3 630 382
- DE-B- 1 614 880
- PATENT ABSTRACTS OF JAPAN vol. 6, no. 67 (E-104)(945) 28. April 1982 & JP-A-57 007 170 ( NITSUSHIN ) 14. Januar 1982

## Beschreibung

Die Erfindung betrifft ein Verfahren zum Herstellen eines optoelektronischen Koppelelements nach dem Oberbegriff des Anspruchs 1.

Aus DE 36 30 382 A1 ist es bekannt zur optischen Verbindung von 2 optoelektronischen Bauelementen das Gehäuse des einen Bauelements mit einem integrierten Hohlzylinder als Steckerhülse, das Gehäuse des zweiten Bauelements als Stecker auszubilden und den Stecker direkt in die Steckerhülse zu stecken. Weiterhin ist aus dieser Druckschrift bekannt, das als Stecker ausgebildete Bauelement mit einem Gehäuse einer handelsüblichen LED zu versehen. Die Gehäuseform des als Steckerhülse vorgesehenen Elements ist von optoelektronischen Bauelementen her bekannt, die zur Ein- bzw. Auskopplung eines optischen Signals in einen Lichtwellenleiter dienen. Zur Steigerung des optischen Koppelfaktors ist wenigstens eines der beiden Bauelemente mit einer Linse versehen. Hergestellt werden die beiden Teilgehäuse durch übliche Verfahren, wie z. B. Eingießen, Einpressen und Spritzgießen, wie sie von der LED-Fertigung her bekannt sind.

Da die optoelektronischen Bauelemente in vollständigen Gehäusen untergebracht sind und vom Gehäusematerial allseitig umgeben sind, bestehen die Gehäuse zweckmäßigerweise aus transparentem, lichtdurchlässigem Material. Dadurch kommt es zu einer nicht unwesentlichen Abstrahlung der Lichtleistung des Senders nach außen. Zu der schlechten Lichtkopplung kommt noch die Fremdlichteinstrahlung von außen hinzu, was die Qualität eines solchen Optokopplers weiter verschlechtert. Um das Gehäuse optisch dicht zu machen, ist ein zweites äußeres Gehäuse vorgesehen, welches das erste Gehäuse vollständig umgibt. Durch diese Maßnahmen sind jedoch eine Reihe weiterer zusätzlicher Produktionsschritte erforderlich.

Aus Patent Abstract of Japan, Band 6, Nummer 67 (E-104) [945], 28. April 1982 und JP-A 57-71 70 ist ein optoelektronisches Koppelelement bekannt, bei dem mit separaten Gehäusen versehene Lichtsender und -empfänger in als verschraubbare Stecker und Steckerhülse ausgebildete Gehäusekörper angeordnet sind. Die Anschlußbeinchen der Bauelemente sind durch die Gehäusekörper nach außen geführt.

Bei dem in der DE-A 16 14 880 beschriebenen Verfahren zum Herstellen eines Optokopplers werden die optischen Elemente jeweils auf einem Sockel montiert und kontaktiert. Anschließend werden die beiden Sockel mittels eines isolierenden Rings miteinander verbunden, so daß die Elemente sich in dem vom Ring gebildeten Innenraum gegenüberliegen und die Sockel den Ring nach außen abschließen. Bei diesem Verfahren werden drei Teile zu dem Gehäuse des Koppelelements zusammengefügt. Die optischen Elemente sind nicht von einem weiteren, zusätzlichen Gehäuse umgeben.

Aufgabe der Erfindung ist es, ein Verfahren zum Herstellen eines optoelektronischen Koppelbauelements anzugeben, wobei das Gehäuse aus zwei zusammensteckbaren Teilen besteht, von denen jedes Teil mindestens ein optoelektronisches Halbleiterbauelement aufnimmt und ein Teil als Stecker, der andere Teil als Steckerhülse ausgebildet ist und die oben aufgeführten Nachteile vermeidet, und wenige Verfahrensschritte aufweist.

Diese Aufgabe wird gelöst durch das erfindungsgemäße Verfahren mit den kennzeichnenden Merkmalen des Anspruchs 1. Die vorteilhafte Ausgestaltung des Verfahrens ergibt sich aus den Unteransprüchen.

In einer vorteilhaften Ausgestaltung des Verfahrens werden in einem ersten Verfahrensschritt die beiden Kontaktstreifen mit einem Kunststoff umgossen. Dabei wird ein Streifen als Stecker und ein zweiter Streifen als Steckerhülse ausgebildet. Stecker und Steckerhülse weisen Aussparungen zur Aufnahme der optoelektronischen Bauelemente auf. In diesen Aussparungen sind die Kontaktstreifen so freigelegt, daß die optolelektronischen Halbleiterbauelemente elektrisch angeschlossen werden können. Nach dem Kontaktieren der Halbleiterbauelemente durch Verkleben mit den Kontaktstreifen mit einem leitfähigen Klebstoff oder durch Verbindung anhand von Bonddrähten werden in einem abschließenden Verfahrensschritt die Gehäuseteile zusammengefügt. Anschließend wird die Verbindung der Gehäuseteile fixiert. Das kann mit Hilfe eines Rasters in der Steckverbindung geschehen, eine andere Ausgestaltung des Verfahrens sieht das Verkleben bzw. das Verschweißen des Gehäuses vor.

In einer weiteren vorteilhaften Ausgestaltung der Erfindung werden die optoelektronischen Halbleiterbauelemente vor dem Zusammenfügen der Gehäuseteile mit einem Tropfen Harz versehen. Beim Zusammenstecken der Gehäuseteile verfließen die Harztropfen der gegenüberliegenden Bauelemente und stellen so die optische Verbindung her. Gleichzeitig werden die Gehäuseteile fixiert. In einer vorteilhaften Weiterbildung des Verfahrens werden die Gehäuseteile in einer quaderförmigen Grundform hergestellt. Dadurch lassen sich die fertigen Bauelemente durch automatische Leiterplattenbestückungsanlagen verarbeiten.

Zu den Vorteilen des erfindungsgemäßen Verfahrens zählt insbesondere, daß die optoelektronischen Halbleiterbauelemente nicht in den Kunststoff der Gehäuseteile eingegossen, sondern auf vorgefertigte Gehäuseteile montiert werden. Daher können für das Gehäusematerial beliebig transparente, opake oder lichtundurchlässige Kunststoffe gewählt werden. Im Normalfall wird man einen lichtundurchlässigen Kunststoff wählen, so daß das Gehäuse optisch dicht wird. Der Harztropfen zwischen den Halbleiterbauelementen erhöht zum einen den optischen Koppelfaktor und zum anderen die elektrische Hochspannungsfestigkeit des nach der Erfindung gefertigten Bauelements.

Im folgenden wird die Erfindung anhand der Figuren erläutert.

Es zeigen:
- Figur 1:: mit Kunststoff umgossene Kontaktstreifen in einer Stufe des Verfahrens,
- Figur 2:: Kontaktstreifen mit montiertem Element in einer weiteren Stufe des Verfahrens,
- Figur 3:: Schnitt durch das optoelektronische Koppelelement in Seitenansicht,
- Figur 4:: Schnitt durch das optoelektronische Koppelelement in Aufsicht.

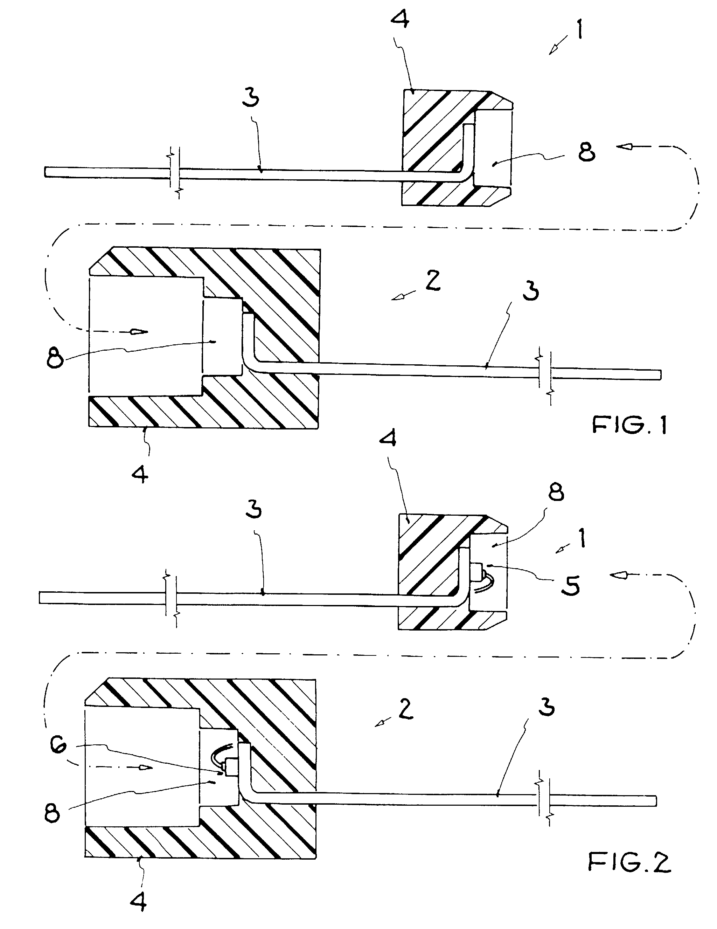

Die Figur 1 zeigt die beiden Gehäuseteile 1, 2 des optoelektronischen Koppelelements in einem ersten Stadium des erfindungsgemäßen Herstellverfahrens. Die Kontaktstreifen 3 bestehen aus einer Reihe von Anschlußfahnen, die einen gemeinsamen Trägerstreifen aufweisen. Die Anschlußfahnen sind in Gruppen gegliedert, die zu einem Gehäuseteil 1, 2 mit Kunststoff 4 umformt werden. So weisen Stecker 1 und Steckerhülse 2 in diesem Ausführungsbeispiel je 4 Anschlußfahnen auf, so daß im fertig montierten optoelektronischen Koppelelement insgesamt 8 Anschlußbeinchen vorhanden sind. Die Anzahl der Anschlußfahnen ist nur durch die Anzahl der jeweils von den Elementen 5, 6 benötigten elektrischen Zuführungen vorgegeben und ansonsten frei wählbar. So ist es durchaus möglich, mehrere Elemente in jedes Gehäuseteil zu montieren. Diese Gruppen von Anschlußfahnen, im folgenden kurz Kontaktstreifen 3 genannt, werden in einem ersten Verfahrensschritt durch bekannte Techniken, wie z. B. durch Spritzgußverfahren, mit einem Kunststoffformteil 4, umgeben. Diese Kunststofformteile 4 werden bei einem Teil als Stecker 1, bei einem anderen Teil der Kontaktstreifen als Steckerhülse 2 ausgebildet. Dabei kann das Kunststofformteil 4 des Steckers 1 formschlüssig in das entsprechende Gegenstück der Steckerhülse 2 hineingesteckt werden. Die exakte Formgebung von Stecker 1 und Steckerhülse 2 ist von der gewünschten Gehäuseform des optoelektronischen Kopplers abhängig und läßt sich an diese durch konstruktive Maßnahmen anpassen. Die Innenseite von Stecker und Steckerhülse weist je eine Aussparung 8 auf. In diesen Aussparungen 8 sind Teile der Kontaktstreifen 3 freigelegt. Im Ausführungsbeispiel sind die mit dem Kunststofformteil umgossenen Enden des Kontaktstreifens 3 abgewinkelt. Die abgewinkelte Längsseite des Kontaktstreifens 3 ist am Boden der Aussparung 8 freigelegt. Im zusammengesteckten Zustand liegen die Böden der Aussparungen 8 von Stecker 1 und Steckerhülse 2 einander gegenüber.

Die Figur 2 zeigt die beiden Gehäuseteile 1, 2 des optoelektronischen Koppelelements in einem zweiten Stadium des erfindungsgemäßen Herstellverfahrens. Hierbei werden die optoelektronischen Elemente 5, 6 in die Aussparungen 8 von Stecker 1 und Steckerhülse 2 montiert. Die Montage erfolgt im Ausführungsbeispiel mit Hilfe eines leitfähigen Klebstoffs derart, daß der Rückseitenkontakt des Elements 5, 6 elektrisch mit einer Anschlußfahne des Kontaktstreifens 3 verbunden ist. In einer anderen Ausführungsform wird das Element 5, 6 mit dem abgewinkelten Ende der Anschlußfahne verlötet, wobei gleichzeitig ein elektrischer Kontakt zur Rückseitenelektrode des Elements 5, 6 zustande kommt. Auch andere Montagetechniken, wie z. B. Verkleben mit dem Kunststofformteil 4 in der Aussparung 8, können Anwendung finden. Die weiteren elektrischen Anschlüsse werden von der freiliegenden Oberfläche des optoelektronischen Elements durch Anschlußleitungen zu den jeweils dafür vorgesehenen Anschlußfahnen des Kontaktstreifens 3 hergestellt. Dies kann zum Beispiel durch bekannte Drahtbondverfahren erfolgen.

Nachdem die Elemente 5, 6 in den Aussparungen 8 von Stecker 1 und Steckerhülse 2 montiert sind und die erforderlichen elektrischen Anschlüsse hergestellt wurden, werden bei dem Ausführungsbeispiel die Aussparungen 8 von Stecker 1 und Steckerhülse 2 mit einem Harztropfen ausgefüllt. Beim anschließenden Zusammenstecken von Stecker 1 und Steckerhülse 2 zerfließen die beiden Harztropfen und sorgen damit für eine verbesserte optische Kopplung der Elemente.

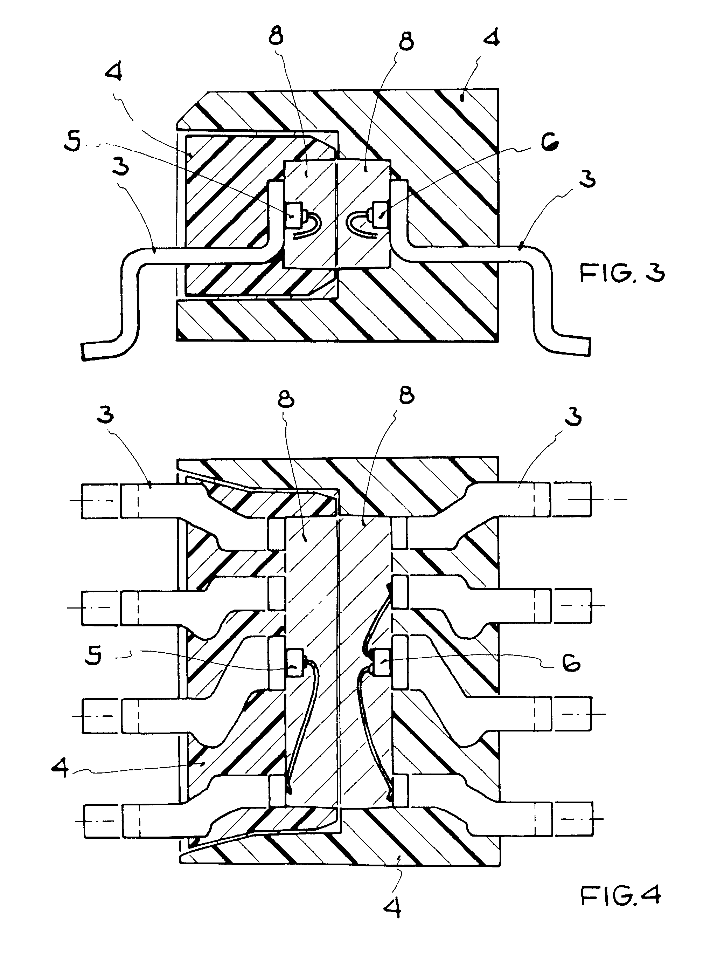

Die Figuren 3 und 4 zeigen Schnitte durch ein optoelektronisches Koppelelement, das nach dem erfindungsgemäßen Verfahren hergestellt wurde, in Seitenansicht und Aufsicht. Die beiden optoelektronischen Elemente 5, 6 sind so in den Aussparungen 8 von Stecker 1 und Steckerhülse 2 angeordnet, daß sich die Elemente 5, 6 im wesentlichen gegenüberliegen. Die Verbindung von Stecker 1 und Steckerhülse 2 wird im Ausführungsbeispiel durch Verschweißen der beiden Gehäuseteile 1, 2 fixiert. Eine weitere Ausgestaltung des Verfahrens erzielt eine Fixierung der Verbindung von Stecker und Steckerhülse durch ein Verkleben der beiden Gehäuseteile. In einer weiteren Ausgestaltung wird eine zusätzliche Fixierung durch konstruktive Maßnahmen bei der Gestaltung von Stecker 1 und Steckerhülse 2 erreicht. Ein Rastmechanismus sichert dabei die Verbindung der beiden Gehäuseteile 1, 2 entweder alleine oder zusätzlich zu den oben bereits beschriebenen Maßnahmen.

Um eine bessere optische Kopplung zwischen den Elementen zu erzielen, ist in einer Weiterbildung des erfindungsgemäßen Verfahrens der von den Aussparungen 8 gebildete Innenraum mit einer Reflexionsschicht versehen, so daß die optische Strahlung daran reflektiert wird. In einer weiteren Ausgestaltung der Erfindung wird das Kunststoffmaterial 4 der Gehäuseteile 1, 2 so gewählt, daß eine reflektierende Oberfläche im von den Aussparungen 8 gebildeten Innenraum entsteht.

Der Vorteil des erfindungsgemäßen Verfahrens ist insbesondere darin zu sehen, daß - im Gegensatz zu den bekannten Verfahren zur Herstellung von optoelektronischen Koppelelementen - die optoelektronischen Elemente in vorgefertigte Gehäuseteile montiert und die Gehäuseteile anschließend lediglich zusammengesteckt werden. Auf ein Moldverfahren kann hierbei verzichtet werden, da die Kunststoffgehäuseteile z. B. durch bekannte Spritzgußtechniken hergestellt werden können. Das erfindungsgemäße Verfahren wird dadurch billiger und einfacher als bekannte Verfahren zum Herstellen von optoelektronischen Koppelelementen.

## Patentansprüche

1. Verfahren zum Herstellen eines optoelektronischen Koppelelements mit einem mehrteiligen Gehäuse, wobei ein erster Gehäuseteil (1) als Stecker und ein zweiter Gehäuseteil (2) als den Stecker aufnehmende Steckerhülse ausgebildet ist und im ersten und zweiten Gehäuseteil je wenigstens ein optoelektronisches Element (5, 6) auf einem Kontaktstreifen (3) montiert ist, dadurch gekennzeichnet, daß zunächst der erste und der zweite Gehäuseteil (1, 2) um je einen Kontaktstreifenteil (3) geformt werden, daß in einem weiteren Verfahrensschritt die optoelektronischen Elemente (5, 6) in Aussparungen (8) in den Innenseiten von Stecker (1) und Steckerhülse (2) montiert werden, daß nach dem Herstellen der elektrischen Verbindungen der optoelektronischen Elemente mit den jeweiligen Anschlüssen (3) Stecker (1) und Steckerhülse (2) zusammengefügt werden.

2. Verfahren nach Anspruch 1, dadurch gekennzeichnet, daß die Montage der optoelektronischen Elemente (5, 6) durch Verlöten mit dem freiliegenden Anschluß des Kontaktstreifens (3) erfolgt.

3. Verfahren nach Anspruch 1, dadurch gekennzeichnet, daß die Montage der optoelektronischen Elemente (5, 6) durch Verkleben mit dem freiliegenden Anschluß des Kontaktstreifens (3) mittels leitfähigen Klebstoffs erfolgt.

4. Verfahren nach einem der Ansprüche 1 bis 3, dadurch gekennzeichnet, daß die elektrische Verbindung zwischen dem optoelektronischen Element (5, 6) und den Anschlüssen der Kontaktstreifen (3) durch Drahtbonden hergestellt wird.

5. Verfahren nach einem der Ansprüche 1 bis 4, dadurch gekennzeichnet, daß ein Rückseitenkontakt des optoelektronischen Elements (5, 6) durch die Montage auf dem Anschluß des Kontaktstreifens elektrisch mit diesem verbunden ist.

6. Verfahren nach einem der Ansprüche 1 bis 5, dadurch gekennzeichnet, daß das beim Zusammenfügen von Stecker (1) und Steckerhülse (2) entstehende, durch die Aussparungen (8) eingeschlossene Volumen mit einem Harz ausgefüllt wird.

7. Verfahren nach einem der Ansprüche 1 bis 6, dadurch gekennzeichnet, daß die Verbindung der beiden Gehäuseteile (1, 2) durch einen Klebstoff fixiert wird.

8. Verfahren nach einem der Ansprüche 1 bis 7, dadurch gekennzeichnet, daß die Verbindung der beiden Gehäuseteile (1, 2) durch die Ausbildung von Rasten fixiert wird.

9. Verfahren nach einem der Ansprüche 1 bis 8, dadurch gekennzeichnet, daß die Aussparungen (8) der beiden Gehäuseteile (1, 2) mit einer Reflexionsschicht versehen sind.

10. Verfahren nach einem der Ansprüche 1 bis 9, dadurch gekennzeichnet, daß die optoelektronischen Elemente (5, 6) so montiert werden, daß sie sich im wesentlichen gegenüberliegen.

## Claims

1. A process for the production of an opto-coupler comprising a multi-part housing, wherein a first housing part (1) is formed as plug and a second housing part (2) is formed as socket which receives the plug, and in the first and second housing parts at least one optoelectronic element (5, 6) is in each case mounted on a contact strip (3), characterised in that initially the first and second housing parts (1, 2) are each formed around a contact strip part (3), that in a further process step the optoelectronic elements (5, 6) are mounted in recesses (8) in the interiors of plug (1) and socket (2), that following the establishment of the electrical connections between the optoelectronic elements and the respective terminals (3), plug (1) and socket (2) are assembled.

2. A process according to Claim 1, characterised in that the mounting of the optoelectronic elements (5, 6) is effected by soldering to the exposed terminal of the contact strip (3).

3. A process according to Claim 1, characterised in that the mounting of the optoelectronic elements (5, 6) is effected by adhesion to the exposed terminal of the contact strip (3) by means of conductive adhesive.

4. A process according to one of Claims 1 to 3, characterised in that the electrical connection between the optoelectronic element (5, 6) and the terminals of the contact strips (3) is established by wire bonding.

5. A process according to one of Claims 1 to 4, characterised in that a rear contact of the optoelectronic element (5, 6) is electrically connected to the contact strip terminal by virtue of the mounting of the optoelectronic element thereon.

6. A process according to one of Claims 1 to 5, characterised in that the space formed upon the assembly of plug (1) and socket (2) and enclosed by the recesses (8) is filled with a resin.

7. A process according to one of Claims 1 to 6, characterised in that the connection between the two housing parts is fixed by an adhesive.

8. A process according to one of Claims 1 to 7, characterised in that the connection between the two housing parts (1, 2) is fixed by the formation of latching means.

9. A process according to one of Claims 1 to 8, characterised in that the recesses (8) of the two housing parts (1, 2) are provided with a reflective coating.

10. A process according to one of Claims 1 to 9, characterised in that the optoelectronic elements (5, 6) are mounted such that they lie substantially opposite one another.

## Revendications

1. Procédé de fabrication d'un élément de couplage optoélectronique équipé d'un boîtier en plusieurs parties, une première partie de boîtier (1) étant réalisée sous forme de fiche et une seconde partie de boîtier (2) étant réalisée en tant que douille recevant la fiche et dans la première et dans la seconde parties de boîtier est monté respectivement au moins un élément optoélectronique (5, 6) sur une bande de contact (3), caractérisé en ce que tout d'abord, la première et la seconde parties de boîtier (1, 2) sont formées chacune autour d'un élément de bande de contact (3), en ce qu'au cours d'une autre étape de procédé les éléments optoélectroniques (5, 6) sont montés dans des évidements (8) dans les côtés intérieurs de la fiche (1) et de la douille (2), en ce qu'après la réalisation des liaisons électriques des éléments optoélectroniques avec les bornes respectives (3) sont réunies la fiche (1) et la douille (2).

2. Procédé selon la revendication 1, caractérisé en ce que le montage des éléments optoélectroniques (5, 6) s'effectue par soudage avec la borne libre de la bande de contact (3).

3. Procédé selon la revendication 1, caractérisé en ce que le montage des éléments optoélectroniques (5, 6) s'effectue par collage avec la borne libre de la bande de contact (3) au moyen d'un matériau conducteur.

4. Procédé selon l'une quelconque des revendications 1 à 3, caractérisé en ce que la liaison électrique entre l'élément optoélectronique (5, 6) et les bornes de la bande de contact (3) est réalisée par liaison par fil.

5. Procédé selon l'une quelconque des revendications 1 à 4, caractérisé en ce qu'un contact postérieur de l'élément optoélectronique (5, 6) est relié électriquement avec celui-ci par le montage sur la borne de la bande de contact.

6. Procédé selon l'une quelconque des revendications 1 à 5, caractérisé en ce que lors de l'assemblage de la fiche (1) et de la douille (2), des volumes inclus existants dans les évidements (8) sont remplis de résine.

7. Procédé selon l'une quelconque des revendications 1 à 6, caractérisé en ce que la liaison des deux parties de boîtier (1, 2) est fixée à l'aide d'un adhésif.

8. Procédé selon l'une quelconque des revendications 1 à 7, caractérisé en ce que la liaison des deux parties de boîtier (1, 2) est fixée par la réalisation de crans d'arrêt.

9. Procédé selon l'une quelconque des revendications 1 à 8, caractérisé en ce que les évidements (8) des deux parties de boîtier (1, 2) sont munis d'une couche réfléchissante.

10. Procédé selon l'une quelconque des revendications 1 à 9, caractérisé en ce que les éléments optoélectroniques (5, 6) sont montés sensiblement de manière en vis-à-vis l'un de l'autre.
